Europäisches Patentamt

(19) European Patent Office

Office européen des brevets

(11) Publication number : **0 434 436 A2**

(12) **EUROPEAN PATENT APPLICATION**

(21) Application number : 90314052.3

(22) Date of filing : 20.12.90

(51) Int. Cl.⁵ : **H01L 39/24**

(30) Priority : 20.12.89 JP 332193/89

(43) Date of publication of application :
26.06.91 Bulletin 91/26

(84) Designated Contracting States :
**DE FR GB IT**

(71) Applicant : **SHARP KABUSHIKI KAISHA**
**22-22 Nagaike-cho Abeno-ku**
**Osaka 545 (JP)**

(72) Inventor : **Ohno, Eizo**
**37-305, Heijo-dai 2-danchi, 2-1-2, Ukyo**
**Nara-shi, Nara (JP)**
Inventor : **Nagata, Masaya**
**1-20-405, Nishi-machi, Tsurumai**
**Nara-shi, Nara (JP)**
Inventor : **Koba, Masayoshi**
**51-14-5, 1-chome, Nishi-machi**
**Shichijo, Nara-shi, Nara (JP)**

(74) Representative : **Brown, Kenneth Richard et al**
**R.G.C. Jenkins & Co. 26 Caxton Street**
**London SW1H 0RJ (GB)**

(54) **Deposition apparatus and method for manufacturing a mono-crystalline oxide superconductor thin film.**

(57)   A deposition apparatus for manufacturing a monocrystalline oxide superconductor thin film comprising (a) a vacuum chamber, (b) a substrate arranged in said vacuum chamber, (c) a plurality of deposition sources arranged in said vacuum chamber opposite to said substrate, (d) a shutter arranged between the substrate and the deposition sources, (e) an oxygen supplier arranged near said substrate, said oxygen supplier having a plurality of nozzles directed to the surface of the substrate in order to supply oxygen gas to the surface of the substrate.

Fig.1

EP 0 434 436 A2

# DEPOSITION APPARATUS AND METHOD FOR MANUFACTURING A MONOCRYSTALLINE OXIDE SUPERCONDUCTOR THIN FILM

## BACKGROUND OF THE INVENTION

The present invention relates to an apparatus and a method for manufacturing a monocrystalline oxide super-conductor thin film.

## PREVIOUS ART

Previously, an oxide superconductor thin film, herein referred to as a "superconductor thin film" has been manufactured by using the following two basic methods. In the first method, a Y-Ba-Cu-O amorphous film is deposited with the vacuum deposition technique on a substrate to be heated, and next the film is annealed in an oxygen environment in order to obtain the superconducting characteristics. In the second method, after putting a substrate in a vacuum, a crystalline thin film is deposited directly onto the substrate with the sputtering technique in an oxygen environment. In this method, annealing in oxygen is necessary because the film just after the deposition does not show superconducting characteristics. In the above-mentioned two methods, annealing in oxygen is necessary finally in order to have good superconducting characteristics. However, this process is a large obstacle on applying a superconductor thin film to a thin film device or the like.

Further, it is important for a device or the like that the crystal orientations in a superconductor thin film are in order. However, when an amorphous film is annealed in oxygen, the uniqueness of crystal orientation is not realized, and many crystal grain boundaries exist.

Ion beam sputtering technique and reactive vacuum deposition technique are used in methods for manufacturing a superconductor thin film, wherein annealing is not needed. In both techniques, oxygen gas should be supplied homogeneously onto a substrate on preparing a monocrystalline thin film. However, this is very difficult in those techniques

For example, in the reactive deposition technique, raw materials in a crucible are heated with an electron beam to be evaporated and to be deposited on a substrate in oxygen gas or in oxygen plasma. However, when raw materials are heated and melted with an electron beam on supplying oxygen gas in a chamber of high vacuum, the surface of the raw materials is oxidized, so that the evaporation rate changes largely and stable deposition of a film is difficult. In general, when an oxide is heated, melted and evaporated, with an electron beam, the evaporation rate is very slow when compared with that of a metal not oxidized. If an oxygen environment is introduced in the inside of the chamber after the electron beam power is controlled so as to realize a stable, constant evaporation rate, the surface of the molten raw materials is oxidized, so that the evaporation rate once stabilized changes. Further, it is difficult to stabilize the evaporation rate again, and the evaporation rate has to be controlled by changing the electron beam power largely. Still more, when the oxygen concentration around the substrate is intended to become homogeneous, the operation results in the introduction of a large amount of oxygen gas into the chamber, so that an apparatus, such as an electron beam generator, is liable to be deteriorated or to be damaged.

Furthermore, in order to obtain a large area of monocrystalline thin film, it is necessary to provide oxygen gas of a high concentration on the surface of a substrate homogeneously. However, previous manufacturing methods with use of the reactive deposition technique cannot solve this problem.

On the other hand, in a manufacturing method with use of the ion sputtering technique disclosed in Japanese Patent Laid Open Publication Number 183495/1989, the tip of a nozzle is arranged over a substrate, so that oxygen gas can be supplied concentrated to a point of the substrate. Thus, the oxygen concentration on the substrate cannot be made homogeneous, a thin film produced in this method always becomes uneven. Further, it is difficult to decide optimum deposition conditions from the degree of migration of each sputtered particle of the targets and it is very hard to manufacture a large area of monocrystalline thin film.

## SUMMARY OF THE INVENTION

It is an object of the present invention to provide an improved apparatus and a method for manufacturing a monocrystalline thin film of high temperature superconductor oxide.

A deposition apparatus according to the present invention comprises a vacuum chamber ; a substrate, arranged in said vacuum chamber ; a plurality of deposition sources arranged in said vacuum chamber opposite to said substrate ; a shutter arranged between the substrate and the deposition sources ; an oxygen supplier arranged near said substrate ; said oxygen supplier having a plurality of nozzles directed to the surface of the substrate in order to supply oxygen gas to the surface of the substrate.

A method according to the present invention with use of the above-mentioned deposition apparatus comprises the steps of : putting constituent metals of the oxide superconductor each in one of said deposition sources ; setting said substrate in said vacuum chamber ; evacuating said vacuum chamber ; turning the electric power sources of said deposition sources on to evaporate the metals ; supplying oxygen gas to said substrate with use of said oxygen supplier at the oxygen pressure on the surface of said substrate between $1 \times 10^{-2}$ and $9 \times 10^{-2}$ Torr', and opening said shutter for a predetermined time to deposit a film on said substrate.

It is an advantage of an apparatus and a method according to the present invention that oxygen gas can be supplied to the entire surface of the substrate homogeneously at a high concentration on deposition of a monocrystalline thin film.

## BRIEF DESCRIPTION OF DRAWINGS

Further objects and advantages of the present invention will be apparent from the following description. Reference is being made to the accompanying Drawings, wherein preferred embodiments of the present invention are clearly shown.

Figure 1 is a schematic sectional view of an apparatus of an embodiment according to the present invention.

Figure 2 is a schematic perspective view of a device providing oxygen gas to a substrate.

Figure 3 is a graph of X-ray diffraction pattern of a thin film obtained in the embodiment.

Figure 4 is a graph of the temperature dependence of electrical resistance of a thin film obtained in the embodiment.

Figure 5 is a schematic perspective view of a device of a comparison example.

Figure 6 is an enlarged figure of a thin film obtained in the comparison example observed with an electron microscope.

### Detailed Description of the Drawings

Referring now to the Drawings, wherein like reference characters designate like or corresponding parts throughout the several views, the present invention will be explained in detail.

A superconductor thin film of oxide high temperature superconductor of the composition ratio of $Y_1Ba_2Cu_3O_{7-x}$ is manufactured in an embodiment of the present invention.

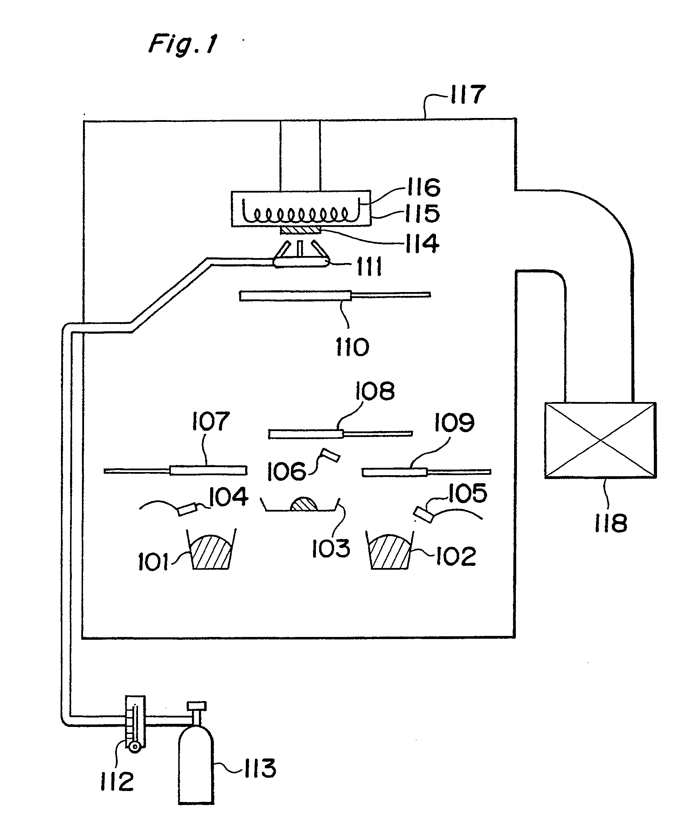

Figure 1 is a schematic diagram of an apparatus of an embodiment of the present invention. In Figure 1, 101 and 102 designates crucibles for electron beam deposition, while 103 designates a boat for resistance heating. In other words, the apparatus has two electron beam generators and a resistance heating device, so that three elements can be deposited independently. Film thickness monitors 104, 105 and 106 are set around the evaporation sources 101, 102 and 103, respectively, for controlling the power for the evaporation sources 101, 102 and 103, so as to make the deposition rate always constant. Shutters 107, 108 and 109 are arranged near the evaporation sources 101, 102 and 103, while a shutter 110 is near a substrate 114. By opening the shutters 107, 108 and 109 when the deposition rates monitored by monitors 104, 105 and 106 become constant and by opening the shutter 110 finally, the controllability of the composition of a thin film deposited on substrate 114. A heater 116 is set in a substrate holder 115, in order to heat the substrate 114. All the above-mentioned equipment is installed in a vacuum chamber 117, which can be evacuated by pumps 118.

An oxygen supplier 111 is arranged near the substrate 114 to supply oxygen gas from an oxygen bomb 113 and a flow-meter 112 is set to monitor the flow rate of oxygen gas.

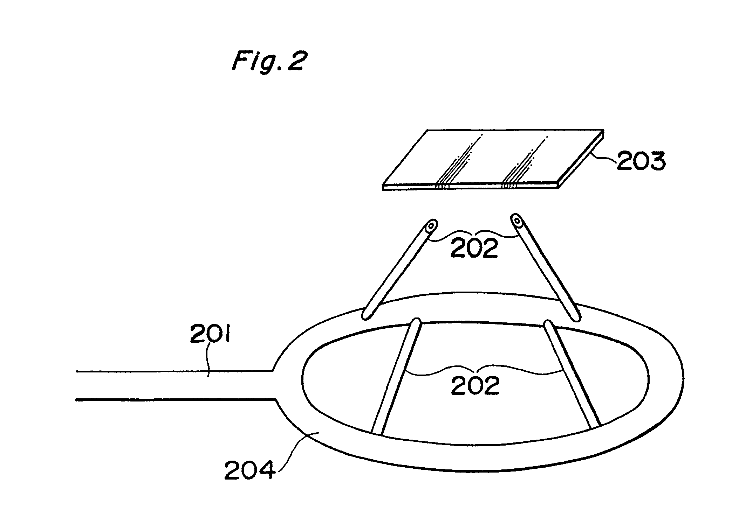

Figure 2 shows the details of the oxygen supplier 111. The pipes which constitute the supplier 111, are made of stainless steel and are heat-resistant. A pipe 201 introduces oxygen gas from the oxygen bomb 113 outside the vacuum chamber 117 (Figure 1). The inner diameter of the pipe 201 is not so restricted, and it is 5 mm in the present embodiment. The pipe 201 is connected to an oval-like pipe 204 of the same inner diameter. Four nozzles 202, directed to the substrate 114, are connected to the pipe 204 so that they can be arranged symmetrically to the center of the substrate 203, in order to obtain a homogeneous film on the entire surface of the substrate 203. The number of the nozzles 202 may be four to ten, the inner diameter of the nozzles may be 0.3 to 1 mm, and the length of the nozzles 202 may be 5 to 20 mm. That is, the inner radius is much smaller than the length. The distance from the tip of the nozzle 202 to the surface of the substrate 203 is 7 mm in the vertical direction to the substrate 203. The size of the substrate 203 is 10 $\times$ 10 mm$^2$.

Next, the steps for manufacturing a superconductor thin film will be explained in detail.

First, metals of yttrium and barium are put in the crucibles 101 and 102 for electron beam deposition, respectively, while copper metal is put in the boat 103 for resistance heating. The vacuum chamber 117 is evacuated by the vacuum pump 118 to get a vacuum of $5 \times 10^{-6}$ Torr around the deposition sources. Next, the substrate 114 is heated up to 650°C with the heater 116. Then, the electric powers for the deposition sources of the crucibles 101, 102 and 103 are turned on and they are controlled with the film thickness monitors 104, 105 and 106, so that the com-position on the substrate 114 on deposition becomes Y : Ba : Cu = 1 : 2 : 3. In this embodiment, a (100) plane of MgO single crystal is used as the substrate 114. Next, oxygen gas of 5 to 20 cc/min, preferably of 10 cc/min, is supplied to the substrate 114 by the oxygen supplier 111 with the use of the flowmeter 112. Thus, the pressure of oxygen gas is realized to be in a range of between $1 \times 10^{-2}$ and $9 \times 10^{-2}$ Torr over the entire surface of the substrate. When oxygen gas is introduced into the vacuum chamber 117, the evaporation rates of the elements become unstable for a short period of time. However, the composition of a film on the substrate returns to Y : Ba : Cu = 1 : 2 : 3 immediately by the control of the evaporation rates with use of the film thickness monitors 104, 105 and 106, and at that time the pressure around the evaporation sources is $6 \times 10^{-4}$ Torr. When the evaporation rates of the elements become stable, the shutter 110 near the substrate is opened to start the deposition of a film. The deposition rate of superconductor film is 0.5 to 1.0 Å/sec, and a film of 2000 to 3000 Å thickness is formed.

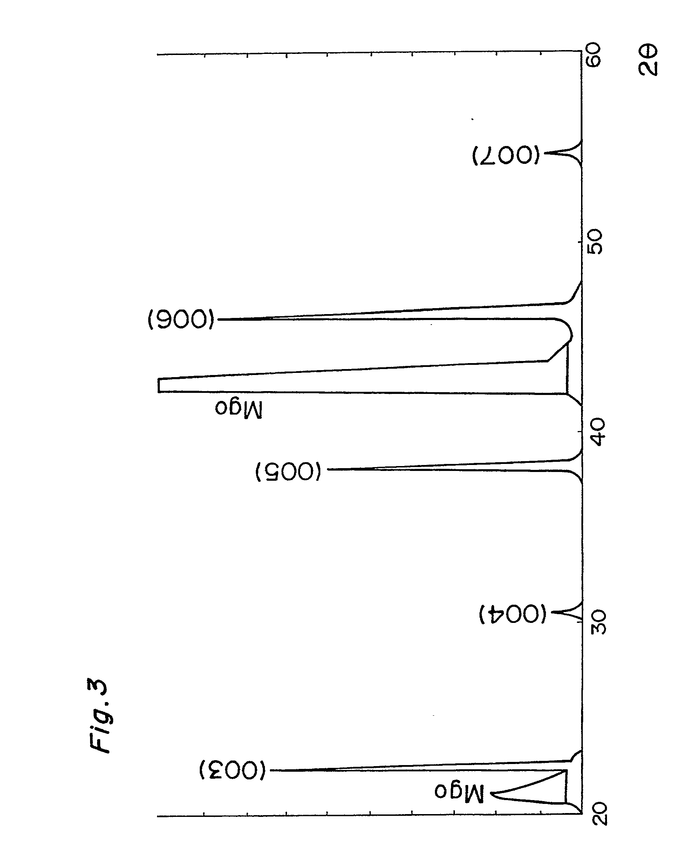

Figure 3 shows an X-ray diffraction pattern of a superconductor thin film manufactured in this embodiment. It is found that a superconductor of the composition ratio of Y : Ba : Cu = 1 : 2 : 3 is obtained, which superconductor is aligned so that the C-axis is vertical to the substrate plane. By observing the entire surface of the film with an electron microscope, it is found that the thin film becomes monocrystalline over $10 \times 10$ mm$^2$ of the entire surface with almost no twin crystals or no grain boundary.

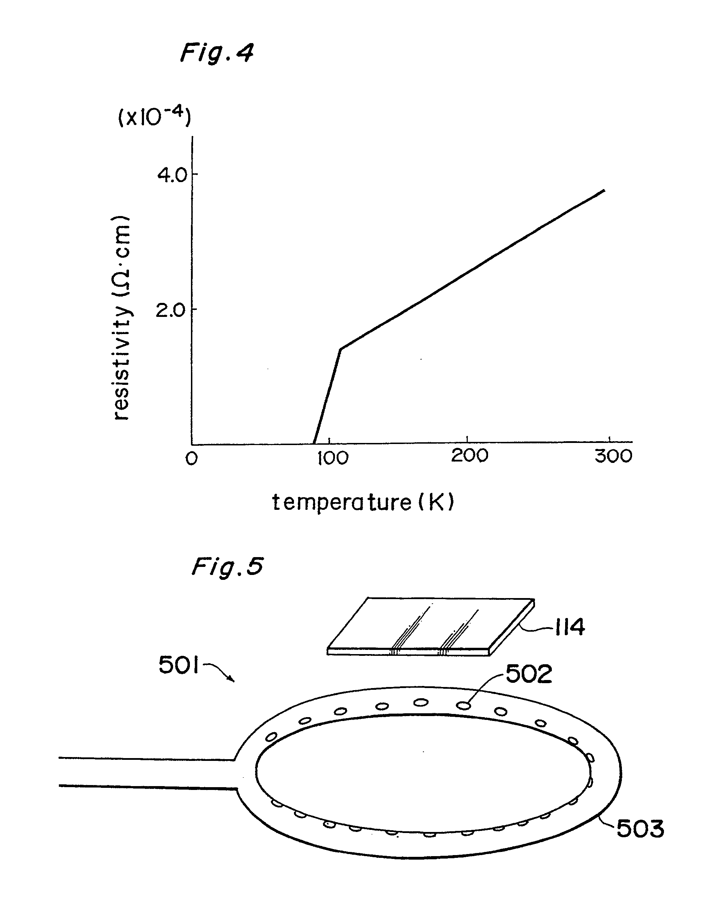

Figure 4 shows the results of the measurement of the temperature dependence of electrical resistance of a superconductor thin film in this embodiment. It is found that the thin film has excellent superconductor characteristics of 90 K of zero resistance temperature.

In this embodiment, a nozzle of 0.5 mm inner diameter is used for the nozzle 202. However, it is confirmed that by using a pipe of inner diameter of 1 mm or below, a superconductor thin film as good as the above-mentioned one can be manufactured.

In this embodiment, because oxygen gas is supplied to the substrate surface from a plurality of nozzles, the oxygen concentration over the substrate becomes homogeneous, so that a monocrystalline thin film of oxide high temperature superconductor can be manufactured.

Further, because the oxygen gas blows out from the nozzles in a limited direction to the substrate, it can make the oxygen pressure near the substrate homogeneous, even if the flow rate is small, and the oxygen pressure around the electron beam generator and the crucibles for materials to be put can be made low. Then, the unstabilization of the evaporation rates of the materials can be prevented, while the deterioration and damages of a deposition apparatus, such as the electron beam generator, can be repressed.

## COMPARISON EXAMPLES

A comparison example will be explained below with reference to the Drawings.

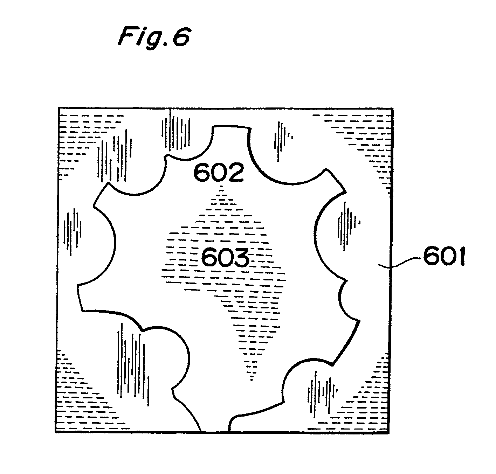

In the comparison example, the apparatus shown in Figure 1 is used, except that a device 501 shown in Figure 5 is used instead of the oxygen supplier 111.

The device 501 includes a ring-shaped pipe 503 having openings 502.

The inner diameter of the pipe 503 is not specially limited, and a pipe of 5 mm inner diameter is used in the comparison example. The radius of the openings 502 is 0.5 mm, while the distance to a substrate 114 is about 1 mm. The substrate has a size of $10 \times 10$ mm$^2$. The number of the openings 502 is not specially limited, while the openings 502 are arranged symmetrically with respect to the center of the substrate 114 in order to supply oxygen homo-geneously.

Next, the comparison example will be explained in detail.

As in the embodiment of the present invention, metals yttrium and barium are put in the crucibles 101 and 102 for electron beam deposition, respectively, while copper metal is put in the boat 103 for resistance heating. The vacuum chamber 117 is evacuated by the vacuum pump 118 to get a vacuum of $5 \times 10^{-6}$ Torr around the deposition sources. Next, the substrate 114 is heated up to 650°C with the heater 116. Then, the electric powers for the deposition sources of the crucibles 101, 102 and 103 are turned on and they are controlled with the film thickness monitors 104, 105 and 106, so that the composition on the substrate 114 on the deposition becomes Y : Ba : Cu = 1 : 2 : 3. In this comparison example, a (100) plane of MgO single crystal is used as the substrate 114. Next, oxygen gas of 10 cc/min is supplied to the substrate 114 by the oxygen supplier 501 with the use of the flowmeter 112. When oxygen gas is introduced into the vacuum chamber 117, the evaporation rates of the elements become unstable for a short period of time. However, the composition of a thin film on the sub-strate returns to Y : Ba : Cu = 1 : 2 : 3 immediately by the control of the evaporation rates with the use of the film thickness monitors 104, 105 and 106 and then the pressure around the evaporation sources is $6 \times 10^{-4}$ Torr. When the evaporation rates of the elements become stable, the shutter 110 near the substrate is opened to start the deposition of film. The deposition rate of superconductor film is 0.5 to 1.0 Å/sec and a film of 2000 to 3000 Å thickness is formed.

Figure 6 shows an enlarged view of the surface of the superconductor thin film manufactured in the comparison example, observed by an electron microscope. As shown in this Figure, a homogeneous superconductor thin film cannot be obtained in this comparison example. In a region 601, near the openings 502, from which oxygen gas flows out, a film nearly deposits because the substrate temperature becomes lower due to oxygen gas, while in a region 603, far from the openings 502, a film having superconductor characteristics, cannot be obtained because the oxygen gas concentration is insufficient. Only in a doughnut-like region 602, between the regions 601 and 603 of about 2 mm width, a superconductor film of 78 K transition temperature is obtained.

The invention being thus described it will be obvious that the same may be varied in many ways. Such variations are not to be regarded as a departure from the scope of the invention.

There are described above novel features which the skilled man will appreciate give rise to advantages. These are each independent aspects of the invention to be covered by the present application, irrespective of whether or not they are included within the scope of the following claims.

## Claims

1. A deposition apparatus for manufacturing a monocrystalline oxide superconductor thin film comprising :

   (a) a vacuum chamber ;

   (b) a substrate arranged in said vacuum chamber ;

   (c) a plurality of deposition sources arranged in said vacuum chamber opposite to said substrate ;

   (d) a shutter arranged between the substrate and the deposition sources ;

   (e) an oxygen supplier arranged near said substrate, said oxygen supplier having a plurality of nozzles directed to the surface of the substrate in order to supply oxygen gas to the surface of the substrate.

2. A deposition apparatus as recited in claim 1, wherein said nozzles of the oxygen supplier are arranged symmetrically around said substrate.

3. A deposition apparatus as recited in claim 1, wherein said nozzles have an inner radius of 0.3 to 1 mm and a length of 5 to 20 mm.

4. A method for manufacturing a monocrystalline thin film of oxide superconductor with a deposition technique utilizing a deposition apparatus as recited in claim 1, comprising the steps of :

   (a) putting constituent metals of the oxide superconductor in each of the said deposition sources ;

   (b) setting said substrate in said vacuum chamber ;

   (c) evacuating said vacuum chamber ;

   (d) turning to the electric power sources of said deposition sources to evaporate the metals ;

   (e) supplying oxygen gas to said substrate with the use of said oxygen supplier at the oxygen pressure on the surface of said substrate between $1 \times 10^{-2}$ and $9 \times 10^{-2}$ Torr and

   (f) opening said shutter for a predetermined time to deposit a film on said substrate.

5. A deposition apparatus for manufacturing a superconductor thin film, comprising a holder for a substrate and a carrier for a vapour deposition source disposed within a chamber, means for varying the amount of vapour produced by the deposition source deposited on the substrate, and a process gas supplier having a plurality of nozzles directed to the surface of the substrate disposed proximate the substrate for supplying process gas uniformly to the substrate.

6. A deposition apparatus according to claim 5 wherein the means for varying is a barrier operable to be opened and closed as a function of the rate of deposition from the deposition sources.

7. A deposition apparatus according to claim 5 or claim 6 further comprising means for monitoring the rate of vapour deposition from the deposition source.

8. A deposition apparatus according to claim 7 wherein the deposition source comprises a plurality of sources and wherein the means for monitoring the vapour deposition rate comprises a plurality of monitors, one disposed for monitoring the vapour deposition rate from each of the plurality of sources, and further comprising a plurality of barriers each disposed between a respective deposition source and the means for varying and operable to be opened and closed in response to a respective one of the plurality of monitors.

9. A method for manufacturing a superconductor thin film, comprising the steps :

   providing a plurality of vapour deposition sources in an evacuable chamber ;

   monitoring the rate of vaporization from the vapour deposition sources ;

   delivering vapour to a substrate when the rate of vaporization is at a predetermined level ; and

   providing a uniform supply of process gas to the surface of the substrate.

10. An oxygen supplier for use in a deposition apparatus comprising a plurality of nozzles for providing oxygen to a substrate, the nozzles being disposed on a looped feed pipe and arranged symmetrically for direction of oxygen uniformly toward a common location.

11. An oxygen supplier according to claim 10 wherein the inner radius of each of the nozzles is substantially smaller than its length.

# Fig.1

# Fig.2

*Fig.3*

## Fig.4

## Fig.5

Fig.6